Europäisches Patentamt

European Patent Office

Office européen des brevets

(19)

(11) EP 1 580 822 A1

(12) EUROPÄISCHE PATENTANMELDUNG

(43) Veröffentlichungstag:
28.09.2005 Patentblatt 2005/39

(51) Int Cl.⁷: H01L 51/20

(21) Anmeldenummer: 04090119.1

(22) Anmeldetag: 24.03.2004

(84) Benannte Vertragsstaaten:
AT BE BG CH CY CZ DE DK EE ES FI FR GB GR
HU IE IT LI LU MC NL PL PT RO SE SI SK TR
Benannte Erstreckungsstaaten:
AL LT LV MK

(71) Anmelder: Samsung SDI Co., Ltd.
Gyeonggi-do (KR)

(72) Erfinder:
• Redecker, Michael
12305 Berlin (DE)
• Fischer, Joerg
13053 Berlin (DE)

• Mathea, Arthur
14197 Berlin (DE)

(74) Vertreter: Hengelhaupt, Jürgen et al
Anwaltskanzlei
Gulde Hengelhaupt Ziebig & Schneider
Wallstrasse 58/59
10179 Berlin (DE)

Bemerkungen:
Geänderte Patentansprüche gemäss Regel 86 (2)
EPÜ.

(54) **Organischer Feldeffekttransistor und Verfahren zu dessen Herstellung**

(57)     Die Erfindung betrifft einen organischen Feldeffekttransistor mit einem Substrat (1), einer Sourceelektrode (2), einer Drainelektrode (6), wobei zwischen Sourceelektrode (2) und Drainelektrode (6) organisches, halbleitendes Material (3) angeordnet ist, einer Gateelektrode (5), welche im Bereich des halbleitenden Materials (3) zwischen Sourceelektrode (2) und Drainelektrode (6) angeordnet ist und einer zwischen Gateelektrode (5) und halbleitendem Material (3) angeordneten Ladungsträger-Sperrschicht (4) sowie ein Verfahren zu dessen Herstellung.

Erfindungsgemäß weist die zwischen Gateelektrode (5) und organischem halbleitenden Material (3) angeordnete Ladungsträger-Sperrschicht (4) ein halbleitendes Material auf. Vorzugsweise besteht die Ladungsträger-Sperrschicht (4) vollständig aus einem halbleitenden Material.

Fig. 2

EP 1 580 822 A1

**Beschreibung**

Die Erfindung betrifft einen organischen Feldeffekttransistor und ein Verfahren zu dessen Herstellung mit den in den Oberbegriffen der Ansprüche 1 und 12 genannten Merkmalen.

Unter dem Oberbegriff der organischen Elektronik sind neben Anwendungen im Bereich der Displayelemente, z.B. der organischen Leuchtdioden, auch Feldeffekttransistoren als Anwendung diskutiert worden. Diese bilden ein weiteres Glied hin zur Realisierung von einfachen elektronischen Schaltungen, die ohne aufwendige Halbleiter-Fabrikationsprozesse hergestellt werden können. Unter anderem können die so hergestellten Schaltungen auf der Basis organischer und polymerer Halbleiter für Transponder-Anwendungen sowie zur Ansteuerung von großflächigen Displays verwendet werden.

Die Definition von p- und n-leitenden Materialien weicht in der organischen Elektronik von der Definition für typische anorganische Halbleiter wie Silizium ab. Während sich die Definition bei klassischen Halbleitern auf die Art der Dotierung stützt, wird p- und n-Leitung bei organischen Halbleitern allgemein auf die Polarität des Ladungsträgers mit der höheren Beweglichkeit bezogen. Insofern besitzen bei n-leitenden Halbleitern Elektronen und bei p-leitenden Halbleitern Defektelektronen eine höhere Beweglichkeit. Dotierungen mit einer Polarität von Überschussladungsträgern sind bei organischen Halbleitern dagegen schwierig einzuführen und im Stand der Technik nur bei organischen Leuchtdioden gebräuchlich (Zhou et al, Appl. Phys. Lett. 81 (2002), p. 4070)

Bei einer auf organischem Material basierenden Feldeffekttransistorstruktur ist halbleitendes, organisches Material zwischen einer Sourceelektrode und einer Drainelektrode angeordnet. Im Bereich (Kanal) zwischen diesen beiden Elektroden wird durch Anlegen einer geeigneten Spannung an der Gateelektrode ein elektrisches Feld erzeugt, wodurch Ladungsträger (Elektronen oder Defektelektronen) in den aus organischem Material bestehenden Kanal eingebracht werden und dort die Leitfähigkeit zwischen Source- und Drainkontakt erhöhen. Dabei wird die Leitung im Kanal bei einer Transistorstruktur mit p-Charakteristik durch Defektelektronen (Löcher), bei einer Transistorstruktur mit n-Charakteristik durch Elektronen realisiert. Der Transistor kann somit durch die Gatespannung gesteuert werden.

Um eine Migration der Gegenladungen von der Gateelektrode in den Kanal zu vermeiden, wodurch das elektrische Feld und damit die Funktionalität der Transistorstruktur abnehmen würde, ist es bekannt, zwischen Kanal und Gateelektrode eine Ladungsträger-Sperrschicht (Dielektrikum) anzuordnen.

Nachteilig an den bekannten organischen Transistorstrukturen ist jedoch deren niedriger maximal erreichbarer Strom. Der maximal erreichbare Strom ist jedoch für die Anwendbarkeit organischer Transistoren, z.B. für Aktiv-Matrix-OLED-Displays von entscheidender Bedeutung.

Der erreichbare Strom hängt unter anderem von der Länge und der Breite des leitfähigen (aus organischem, halbleitendem Material bestehenden) Kanals sowie von der Beweglichkeit der Ladungsträger ab. Typische Materialien sind niedermolekulare Verbindungen wie Pentacen, Tetracen, Oligothiophene sowie Phthalocyanine als p-Halbleiter sowie Derivate von Napthalintetracarbonsäurediimid und Perylentetracarbonsäurediimid, Fullerene und Derivate von Phthalocyaninen als n-Halbleiter. Als polymere Materialien kommen insbesondere p-Halbleiter wie Polyalkylthiophene und Poly (vinylenthienylen)e sowie Copolymere von Alkylthiophenen mit Alkylfluoreneinheiten in Frage. Typische Ladungsträgerbeweglichkeiten $\mu$ liegen im Bereich von $10^{-3}$ cm$^2$/Vs bis 1 cm$^2$/Vs.

Zur Erzielung eines hohen maximalen Stroms sollte die Kanallänge klein sein, während die Kanalbreite und die Beweglichkeit der Ladungsträger hoch sein müssen. Hierbei sind den baulichen Abmessungen jedoch Grenzen gesetzt. Einen weiteren Aspekt stellt die Flächenkapazität $C_i$ des Dielektrikums dar. Eine hohe Kapazität ist wünschenswert, um bereits bei niedrigen Gate-Spannungen $V_{GS}$ eine ausreichende Dichte von Ladungsträgern in Halbleitern zu induzieren.

Der Zusammenhang zwischen dem erreichbaren Strom I im linearen Arbeitsbereich eines organischen Feldeffekttransistors und den wichtigsten Parametern ist in der nachfolgenden Formel dargestellt:

$$I = \frac{C_i \cdot W}{L} \cdot \mu \cdot \left( V_{GS} - V_{th} - \frac{V_{DS}}{2} \right) \cdot V_{DS}$$

Hierbei ist $V_{th}$ die Schwellenspannung des Transistors, $V_{DS}$ ist die zwischen Drainkontakt und Sourcekontakt anliegende Spannung, $V_{GS}$ ist die Gate-Spannung und $\mu$ die Ladungsträgerbeweglichkeit.

Um bei vorgegebenen baulichen Abmessungen einen möglichst hohen, maximal erreichbaren Strom realisieren zu können, müssen Flächenkapazität $C_i$ und Ladungsträgerbeweglichkeit $\mu$ möglichst große Werte annehmen.

Um die Flächenkapazität $C_i$ zu erhöhen, muss die Schichtdicke des Dielektrikums reduziert werden. Eine Reduzierung der Schichtdicke der Ladungsträger-Sperrschicht ist jedoch vor allem durch Parameter wie Defektdichte und Durchschlagsspannung begrenzt.

Darüber hinaus ist die Verwendung von Dielektrika mit hoher relativer Dielektrizitätskonstante zur Erhöhung des schaltbaren Stromes bei organischen Feldeffekttransistoren aus Dimitrakopoulos et al. Science 283 (1999), pp. 822 bekannt. Im beschriebenen Fall wurden Materialien aus der Klasse der ferroelektrischen anorganischen Materialien, wie z.B. Barium-Zirkoniumtitanat als Dielektrikum gewählt. Diese Materialien werden gemäß dem Stand der Technik durch Sputtern aufgebracht. Nachteilhafterweise erfolgt die Herstellung der oben genannten Schichten unter relativ hohem Energieeintrag und bei hohen Prozesstemperaturen. Die Anwendung dieser Verfahren auf organische Funktionsschichten, wie beispielsweise dem zwischen Sourceelektrode und Drainelektrode angeordneten Kanal aus einem organischen, halbleitenden Material, ist daher problematisch. Als Option für einen organischen Feldeffekttransistor bleiben deshalb nur solche Strukturen, bei denen der organische Halbleiter sowie gegebenenfalls weitere organische Funktionsschichten am Ende der Prozesskette aufgebracht werden. Dies ist jedoch nachteilig, weil dadurch die Option entfällt, mit Top-Gate-Strukturen zu arbeiten.

Es ist daher Aufgabe der vorliegenden Erfindung, einen organischen Feldeffekttransistor anzugeben, welcher bei vorgegebenen baulichen Abmessungen einen höheren maximal schaltbaren Strom aufweist. Weiterhin soll ein Verfahren zur Herstellung des erfindungsgemäßen Feldeffekttransistors angegeben werden. Insbesondere soll trotz Verwendung einer Ladungsträger-Sperrschicht mit hoher Dielektrizitätskonstante das Aufbringen der Ladungsträger-Sperrschicht auf das zwischen Sourceelektrode und Draineelektrode angeordnete organische Material ohne relativ hohen Energieeintrag ermöglicht werden.

Diese Aufgaben werden erfindungsgemäß gelöst durch die Merkmale im kennzeichnenden Teil des Anspruchs 1 (Sachanspruch) und des Anspruchs 12 (Verfahrensanspruch) im Zusammenwirken mit den Merkmalen im Oberbegriff. Bevorzugte Ausgestaltungen der Erfindung sind in den Unteransprüchen enthalten.

Dazu weist die zwischen Gateelektrode und organischem halbleitenden Material angeordnete Ladungsträger-Sperrschicht eines organischen Feldeffekttransistors erfindungsgemäß ein halbleitendes Material auf. Vorzugsweise besteht die Ladungsträger-Sperrschicht vollständig aus einem halbleitenden Material. Durch geeignete Wahl der Gateelektrode und der erfindungsgemäß halbleitenden Ladungsträger-Sperrschicht kann erreicht werden, dass Ladungsträger in die Ladungsträger-Sperrschicht (Dielektrikum) eingebracht werden und damit die effektive Schichtdicke dieser Ladungsträger-Sperrschicht erheblich absinkt. Durch eine geringere effektive Schichtdicke kann die Flächenkapazität der Ladungsträger-Sperrschicht (Dielektrikum) und damit der maximal erreichbare Strom des organischen Feldeffekttransistors erheblich erhöht werden.

Im folgenden wird die Wirkungsweise anhand eines Transistors mit p-Kanal erläutert.

In einer bevorzugten Ausführungsvariante ist die Energie des Leitungsbandes der Ladungsträger-Sperrschicht niedriger als die Austrittsarbeit der Gateelektrode und das halbleitende Material des Feldeffekttransistors, welches zwischen Drainelektrode und Sourceelektrode angeordnet ist, besitzt eine höhere Leitungsbandenergie als die (ebenfalls aus halbleitendem Material bestehende) Ladungsträger-Sperrschicht. Zusätzlich muss die Energie des Valenzbandes der Sperrschicht niedriger liegen als die Energie des Valenzbandes des Halbleiters. In einer besonders bevorzugten Ausführungsvariante ist der energetische Abstand zwischen dem Leitungsband der Ladungsträger-Sperrschicht und dem Leitungsband des halbleitendem Materials sowie zwischen dem Valenzband der Sperrschicht und dem Valenzband des Halbleiters größer als 1,0 eV, und der energetische Abstand zwischen dem Leitungsband der Ladungsträger-Sperrschicht und der Austrittsarbeit der Gateelektrode ist kleiner als 0,1 eV.

Durch die vorbeschriebene Anpassung der Materialien der Gateelektrode, der Ladungsträger-Sperrschicht und des zwischen Sourceelektrode und Drainelektrode angeordneten halbleitenden Materials kann eine Injektion bzw. Migration von Elektronen in die Ladungsträger-Sperrschicht bis hin zur Grenzfläche zwischen Ladungsträger-Sperrschicht und organischem halbleitenden Material realisiert werden. Dabei besteht die Ladungsträger-Sperrschicht aus einem n-leitenden Material und das halbleitende, zwischen Sourceelektrode und Drainelektrode angeordnete organische Material (Kanal) aus einem p-leitenden Material.

Eine äquivalente Struktur kann auch durch Kombination eines n-leitenden Materials für den Halbleiter mit einer p-leitenden Ladungsträger-Sperrschicht erzeugt werden. In dieser n-Kanal-Version ist die Austrittsarbeit des Gatekontaktes ähnlich oder gleich der Energie des Valenzbandes der Ladungsträger-Sperrschicht. Dadurch ist die Injektion von Defektelektronen in die Sperrschicht möglich. Zur Vermeidung eines Übertritts von Ladungsträgern zwischen Sperrschicht und n-Kanal muss die Energie des Valenzbandes der Sperrschicht mindestens 1 eV höher sein als die Energie des Valenzbandes des Halbleiters.

Gleichzeitig muss die Energie des Leitungsbandes der Sperrschicht mindestens 1 eV über der Energie des Leitungsbandes des Halbleiters liegen.

Für den Fall eines p-Kanal-Transistors umfasst das zwischen Sourceelektrode und Drainelektrode angeordnete halbleitende Material des organischen Feldeffekttransistors vorzugsweise Pentacen, Tetracen, Phtalocyanine mit niedriger Austrittsarbeit, Oligothiophene, Oligo- und Polyarylamine, Polyalkylthiophene, Copolymere von Alkylthiophenen mit Alkylfluoreneinheiten, Polyfluorene, Poly(thienylenvinylene), Poly(phenylenvinylene), und/oder Homopolymere mit Phenylen, Napthalen- und/oder Anthranyleinheiten.

Die Ladungsträger-Sperrschicht umfasst vorzugsweise Titandioxid, undotiertes Zinnoxid, undotiertes Zinkoxid, Zirkoniumdioxid, Tantaloxid und/oder Zinksulfid aus der Gruppe der anorganischen Materialien sowie Derivate von Perylentetracarbonsäurediimid sowie Napthalintetracarbonsäurediimid aus der Gruppe der organischen Materialien.

Die Gateelektrode des p-leitenden Feldeffekttransistors umfasst vorzugsweise Magnesium, eine Silber aufweisende Magnesiumlegierung, Calcium, Barium und/oder Lanthaniden sowie Scandium und Yttrium.

In einer besonders bevorzugten Ausführungsvariante besteht die Gateelektrode aus einer Legierung von Magnesium und Silber im Verhältnis von 1:9.

Für den Fall eines n-Kanal-Feldeffekttransistors werden als organischer Halbleiter bevorzugt Derivate von Perylentetracarbonsäurediimid sowie Napthalintetracarbonsäurediimid und Derivate von Fulleren verwendet. Die Sperrschicht besteht hier bevorzugt aus Derivaten von oligomeren Arylaminen. Geeignete Materialien für den Gatekontakt sind unter anderem Gold, Palladium, Platin und Nickel.

Bei der oben beschriebenen Wahl der Materialien ist es beispielsweise bei einem p-leitenden Kanal (organisches Material zwischen Drainelektrode und Sourceelektrode) und einer n-leitenden Ladungsträger-Sperrschicht möglich, negative Ladungsträger (Elektronen) in die Ladungsträger-Sperrschicht zu injizieren. Die Elektronen wandern jedoch nur bis zur Grenzfläche zwischen n-leitender Ladungsträger-Sperrschicht und p-leitendem Kanal, wodurch die effektive Schichtdicke deutlich reduziert und der maximal erreichbare Strom des Feldeffekttransistors erfindungsgemäß deutlich erhöht werden kann.

Ein organischer Feldeffekttransistor wird durch Aufbringen einer Sourceelektrode, Aufbringen einer Drainelektrode und Aufbringen von organischem, halbleitenden Material auf ein Substrat, Aufbringen einer Ladungsträger-Sperrschicht und Aufbringen einer Gateelektrode hergestellt, wobei die Ladungsträger-Sperrschicht erfindungsgemäß mittels thermischem Verdampfen oder mittels Elektronenstrahlverdampfung aufgebracht wird. Dabei ist es erfindungsgemäß vorgesehen, für die Ladungsträger-Sperrschicht ein halbleitendes Material zu verwenden. Dieses kann im Gegensatz zu ferroelektrischen anorganischen Materialien, wie z.B. Barium-Zirkoniumtitanat ohne hohen thermischen Eintrag (für die darunter liegenden Schichten) aufgebracht werden. Hierdurch wird es vorteilhafterweise möglich, die Ladungsträger-Sperrschicht direkt auf die organische Schicht (zwischen Source und Drain) des Feldeffekttransistors aufzubringen. Vorzugsweise wird die Elektronenstrahlverdampfung bei einem Sauerstoffpartialdruck von $10^{-4}$ bis $10^{-3}$ mbar vorgenommen.

Die Erfindung wird nachfolgend anhand eines Ausführungsbeispiels näher erläutert.
Es zeigen:

Figur 1     einen organischen Feldeffekttransistor nach dem Stand der Technik in geschnittener, schematischer Darstellung,

Figur 2     einen p-Kanal organischen Feldeffekttransistor nach der Erfindung in schematischer, geschnittener Darstellung und

Figur 3     ein Energieschema des p-Kanal-Transistors mit Gateelektrode, Ladungsträger-Sperrschicht und halbleitender organischer Schicht (Kanal) für ein Ausführungsbeispiel eines erfindungsgemäßen Feldeffekttransistors.

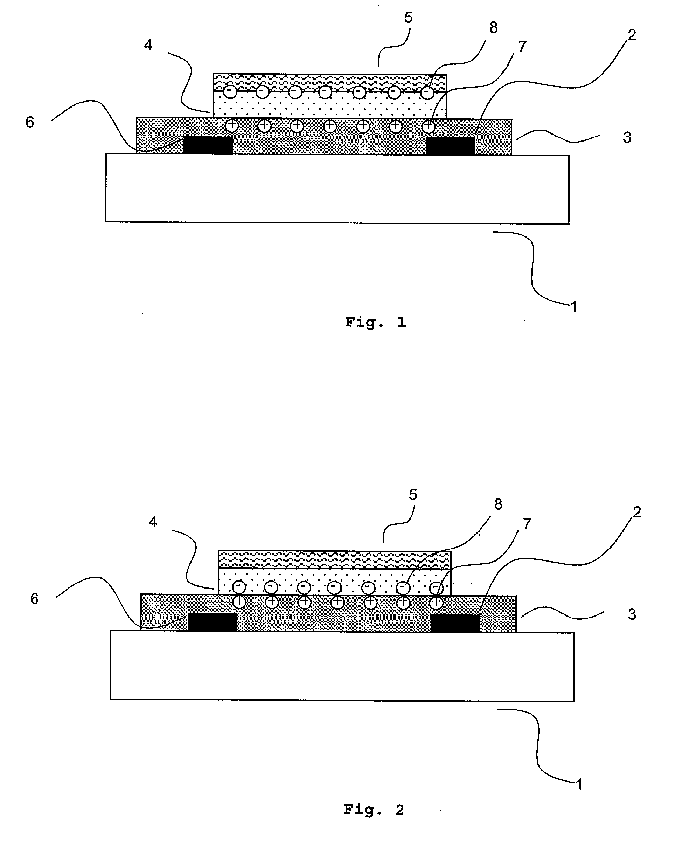

In Figur 1 ist ein organischer Feldeffekttransistor nach dem Stand der Technik dargestellt. Auf einem Substrat 1 sind eine Sourceelektrode 2 und eine Drainelektrode 6 angeordnet. Auf diesen Elektroden 2, 6 ist ein organischer Halbleiter 3 angeordnet. Auf dem Halbleiter 3 ist eine Ladungsträger-Sperrschicht 4 und über dieser Ladungsträger-Sperrschicht 4 die Gateelektrode 5 angeordnet.

Das organische Material 3 ist ein p-leitendes Material. Durch eine geeignete Spannung an der Gateelektrode 5 können Ladungsträger 7, d.h. Defektelektronen in den Kanal 3 eingebracht werden und dort die Leitfähigkeit zwischen Drainelektrode 6 und Sourceelektrode 2 erhöhen. Der Transistor kann somit über die an der Gateelektrode 5 angelegte Spannung gesteuert werden.

Die minimal verwendbare Schichtdicke der Ladungsträger-Sperrschicht 4 ist jedoch durch entsprechende Parameter wie Defektdichte und Durchschlagsspannung begrenzt.

Weiterhin lassen sich ferroelektrische anorganische Materialien wie beispielsweise Barium-Zirkoniumtitanat mit hoher Dielektrizitätskonstante als Ladungsträger-Sperrschicht 4 auf die organische Schicht 3 aufgrund zu hohem Energieeintrages bzw. zu hohen Prozesstemperaturen nicht direkt aufbringen.

Aufgrund der vorgenannten Nachteile (minimale Schichtdicke der Ladungsträger-Sperrschicht 4 nicht beliebig reduzierbar und Materialien für die Ladungsträger-Sperrschicht 4 mit hoher Dielektrizitätskonstante nicht auf organisches Material 3 ohne dessen mögliche Beschädigung auftragbar) ist der maximal erreichbare Strom eines organischen Feldeffekttransistors nach dem Stand der Technik sowie dessen Anwendbarkeit bei vorgegebenen Baumaßen sehr begrenzt.

Mit einem erfindungsgemäßen organischen Feldeffekttransistor können diese Nachteile behoben werden. Ein organischer Feldeffekttransistor nach der Erfindung ist in Figur 2 schematisch dargestellt. Der Aufbau gleicht dem organischen Feldeffekttransistor nach dem Stand der Technik, im Unterschied weist die Ladungsträger-Sperrschicht 4 jedoch ein halbleitendes Material auf. Dadurch können die Ladungsträger 8 (Elektronen) in die Ladungsträger-Sperrschicht 4 bis zur Grenzfläche von Ladungsträger-Sperrschicht 4 und organischer, halbleitender Schicht 3 injiziert werden, wodurch die effektive Schichtdicke der Ladungsträger-Sperrschicht 4 deutlich reduziert und damit der maximal erzielbare Strom des organischen Feldeffekttransistors nach der Erfindung deutlich erhöht werden kann. Um eine Injektion von Elektronen in die (halbleitende) Ladungsträger-Sperrschicht 4 zu realisieren, muss die Barriere für die Injektion von Ladungsträgern in die Ladungsträger-Sperrschicht 4 klein sein. Eine weitere Randbedingung ist, dass die Barrieren für den Übertritt von Ladungsträgern aus der Ladungsträger-Sperrschicht 4 in das organische Material 3 sowie in Gegenrichtung groß gewählt sein müssen, um die Gate-Leckrate des erfindungsgemäßen organischen Feldeffekttransistors niedrig zu halten.

Die Erfüllung der oben genannten Forderungen kann durch geeignete Wahl von Gateelektrode 5, Ladungsträger-Sperrschicht 4 und organischem Material 3 erfüllt werden.

Der erfindungsgemäße organische Feldeffekttransistor weist nicht notwendigerweise ein eigenes Substrat 1 auf; vielmehr ist es möglich, dass der Feldeffekttransistor auf ein Substrat eines anderen Bauelementes, beispielsweise auf das Substrat eines OLED-Displays aufgedruckt wird. In diesem Fall wird das Substrat 1 durch das Substrat des OLED-Displays ausgebildet.

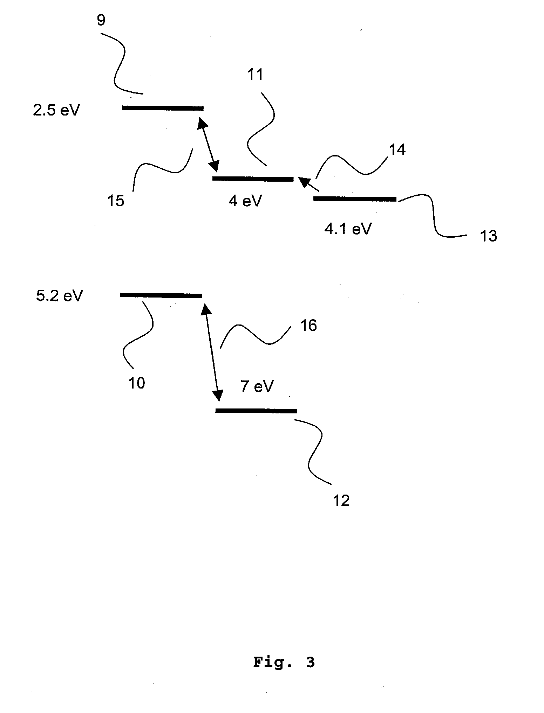

Ein mögliches Energieschema ist in Figur 3 schematisch dargestellt. Dieses Energieschema gilt für den strom- und spannungslosen Fall, in dem keine Bandverzerrungen durch die Ansammlung von Ladungsträgern auftreten. Die angegebenen Energiewerte entsprechen dem Fall eines p-leitenden organischen Halbleitermaterials 3 und einer anorganischen n-leitenden Ladungsträger-Sperrschicht 4. Durch eine entsprechende Wahl der Materialien ist es alternativ jedoch auch möglich, eine äquivalente Struktur mit n-leitendem organischen Material 3 und p-leitender Ladungsträger-Sperrschicht 4 zu realisieren.

Im Ausführungsbeispiel besteht der organische Halbleiter 3 aus Polyalkylthiophen und die Ladungsträger-Sperrschicht 4 aus Titandioxid. Die Gateelektrode 5 besteht aus einer Magnesium-Silberlegierung. Die Injektion von Elektronen vom Gate-Niveau 13 in das Leitungsband 11 der Ladungsträger-Sperrschicht 4 erfolgt über die vernachlässigbar kleine Energiebarriere 14, welche 0,1 eV beträgt. Die injizierten Elektronen können bis zur Grenzschicht zwischen der Ladungsträger-Sperrschicht 4 und dem organischen Halbleiter 3 vordringen, jedoch aufgrund der Energiebarriere 15 nicht in das Leitungsband 9 des organischen Halbleiters 3 übertreten. Im beschriebenen Fall beträgt diese Barriere 1,5 eV. Ebenso ist der Übertritt von Löchern (Defektelektronen) aus dem Valenzband 10 des organischen Halbleiters 3 in das Valenzband 12 der Ladungsträger-Sperrschicht 4 durch die Energiebarriere 16 unterbunden. Im gezeigten Fall beträgt diese Energiebarriere 1,8 eV.

Geeignete Materialien für die Gateelektrode 5 sind unedle Metalle mit Austrittsarbeiten im Bereich von 3,8 bis 4,0 eV, sofern Titandioxid als Ladungsträger-Sperrschicht 4 verwendet wird.

Das Hauptkriterium für die Wahl der Gateelektrode besteht darin, dass keine bzw. nur eine geringe Barriere kleiner 0,1 eV für die Injektion von Ladungsträgern in die Ladungsträger-Sperrschicht 4 besteht. Dem Begriff Ladungsträger-Sperrschicht 4 wird insoweit Rechnung getragen, als Ladungsträger die Grenzfläche zwischen der Ladungsträger-Sperrschicht 4 und dem organischen Material 3 nicht passieren können.

Das erfindungsgemäße Verfahren zur Herstellung eines organischen Feldeffekttransistors durch Aufbringen einer Sourceelektrode, Aufbringen einer Drainelektrode und Aufbringen von organischem halbleitenden Material auf ein Substrat sowie Aufbringen einer Ladungsträger-Sperrschicht und Aufbringen einer Gateelektrode ist dadurch gekennzeichnet, dass die Ladungsträger-Sperrschicht 4 mittels thermischem Verdampfen oder mittels Elektronenstrahlverdampfung aufgebracht wird. Gegenüber der Verwendung anorganischer Ferroelektrika nach dem Stand der Technik zur Erzielung eines hohen maximal erreichbaren Stroms durch Verwendung von Materialien mit hoher Dielektrizitätskonstante können die erfindungsgemäßen halbleitenden Materialien (wie z.B. Titandioxid) für die Ladungsträger-Sperrschicht 4 vorteilhafterweise im Vakuum entweder durch thermisches Verdampfen oder durch Elektronenstrahlverdampfung aufgebracht werden.

Hierdurch wird ein hoher Energieeintrag bzw. ein hoher thermischer Stress auf das organische Material 3 vermieden. Dadurch kann es bei der Fertigung eines organischen Feldeffekttransistors vermieden werden, die organischen Funktionsschichten als letzte in der Produktionskette aufzubringen, wodurch vorteilhafterweise auch Top-Gate-Strukturen realisiert werden können.

Dazu wird beim erfindungsgemäßen Verfahren für einen p-Kanal-Transistor als Material für die Ladungsträger-Sperrschicht 4 ein halbleitendes Material, vorzugsweise Titandioxid verwendet. Die Elektronenstrahlverdampfung wird vorzugsweise bei einem Sauerstoffpartialdruck von $10^{-4}$ bis $10^{-3}$ mbar vorgenommen.

**Bezugszeichenliste**

1 Substrat

2 Sourceelektrode

3 organisches, halbleitendes Material (Kanal)

4 Ladungsträger-Sperrschicht

5     Gateelektrode

6     Drainelektrode

7     Ladungsträger im Kanal

8     Gegenladungen

9     Leitungsbandniveau des organischen Materials

10    Valenzbandniveau des organischen Materials

11    Leitungsbandniveau der Ladungsträger-Sperrschicht

12    Valenzbandniveau der Ladungsträger-Sperrschicht

13    Austrittsarbeit der Gateelektrode

14    Barriere für Elektroneninjektion zwischen Gateelektrode und Ladungsträger-Sperrschicht

15    Barriere für Elektroneninjektion von der Ladungsträger-Sperrschicht in das organische, halbleitende Material Halbleiter

16    Barriere für Lochinjektion vom organischen, halbleitenden Material in die Ladungsträger-Sperrschicht

**Patentansprüche**

**1.** Organischer Feldeffekttransistor aufweisend:

ein Substrat (1), eine Sourceelektrode (2), eine Drainelektrode (6), wobei zwischen Sourceelektrode (2) und Drainelektrode (6) organisches, halbleitendes Material (3) angeordnet ist, eine Gateelektrode (5), welche im Bereich des halbleitenden Materials (3) zwischen Sourceelektrode (2) und Drainelektrode (6) angeordnet ist, wobei zwischen Gateelektrode (5) und halbleitendem Material (3) eine Ladungsträger-Sperrschicht (4) angeordnet ist,

**dadurch gekennzeichnet, dass**
die Ladungsträger-Sperrschicht (4) ein halbleitendes Material aufweist.

**2.** Feldeffekttransistor nach Anspruch 1,
**dadurch gekennzeichnet, dass**
die Ladungsträger-Sperrschicht (4) vollständig aus einem halbleitendes Material besteht.

**3.** Feldeffekttransistor nach einem der vorhergehenden Ansprüche,

**dadurch gekennzeichnet, dass**
die Energie des Leitungsbandes der Ladungsträger-Sperrschicht (4) niedriger ist als die Austrittsarbeit der Gateelektrode (5) und das halbleitende Material (3) eine höhere Energie des Leitungsbandes als die Ladungsträger-Sperrschicht (4) aufweist.

**4.** Feldeffekttransistor nach Anspruch 3,
**dadurch gekennzeichnet, dass**
der energetische Abstand zwischen Ladungsträger-Sperrschicht (4) und halbleitendem Material (3) größer 1,0 eV, insbesondere 1,5 eV beträgt.

**5.** Feldeffekttransistor nach Anspruch 3,
**dadurch gekennzeichnet, dass**
der energetische Abstand zwischen dem Leitungsband der Ladungsträger-Sperrschicht (4) und der Austrittsarbeit der Gateelektrode (5) kleiner 0,2 eV, insbesondere 0,1 eV ist.

**6.** Feldeffekttransistor nach einem der vorhergehenden Ansprüche,
**dadurch gekennzeichnet, dass**
das halbleitende Material (3) für einen p-Kanal-Transistor Pentacen, Tetracen, Phtalocyanine, Oligothiophene, Polyalkylthiophene, Copolymere von Alkylthiophenen mit Alkylfluoreneinheiten, Poly-fluorene, Poly-(thienylenvinylene), Poly(phenylen-vinylene), und/oder Homopolymere mit Phenylen, Napthalen- und/oder Anthranyleinheiten umfasst sowie für einen n-Kanal-Transistor Derivate von Pe-rylentetracarbonsäurediimid sowie Napthalintetra-carbonsäurediimid und Fullerene.

**7.** Feldeffekttransistor nach einem der vorhergehenden Ansprüche,
**dadurch gekennzeichnet, dass**
die Ladungsträger-Sperrschicht (4) für einen p-Kanal-Transistor Titandioxid, undotiertes Zinnoxid, undotiertes Zinkoxid, Zirkoniumdioxid, Tantaloxid und/oder Zinksulfid umfasst und im Falle eines n-Kanal-Transistors bevorzugt Derivate oligomerer Arylamine.

**8.** Feldeffekttransistor nach einem der vorhergehenden Ansprüche,
**dadurch gekennzeichnet, dass**
die Gateelektrode (5) im Falle eines p-Kanal-Transistors Magnesium, eine Silber aufweisende Magnesiumlegierung, Calcium, Barium, und/oder ein Lanthanid und im Falle eines n-Kanal-Transistors Gold, Nickel, Palladium oder Platin umfasst.

**9.** Feldeffekttransistor nach Anspruch 8,
**dadurch gekennzeichnet, dass**
das Lanthanid Cer oder Ytterbium ist.

**10.** Feldeffekttransistor nach Anspruch 8,

**dadurch gekennzeichnet, dass**
die Magnesiumlegierung eine Legierung von Magnesium und Silber im Verhältnis von 1:9 umfasst.

**11.** nach einem der vorhergehenden Ansprüche,
**dadurch gekennzeichnet, dass**
die Sourceelektrode (2) und/oder die Drainelektrode (6) im Falle eines p-Kanal-Transistors Gold, Palladium, Platin und/oder leitfähige Polymere, insbesondere Poly(ethylendioxothiophen)/Poly styrolsulfonsäure und im Falle n-Kanal-Transistors Aluminium, Titan, Magnesium und/oder Silber umfassen.

**12.** Verfahren zur Herstellung eines organischen Feldeffekttransistors mit folgenden Verfahrensschritten:

- Aufbringen einer Sourceelektrode (2), Aufbringen einer Drainelektrode (6) und Aufbringen von organischem, halbleitenden Material (3) auf ein Substrat (1),
- Aufbringen einer Ladungsträger-Sperrschicht (4) und Aufbringen einer Gateelektrode (5),

**dadurch gekennzeichnet, dass**
die Ladungsträger-Sperrschicht (4) mittels thermischem Verdampfen oder mittels Elektronenstrahlverdampfung aufgebracht wird.

**13.** Verfahren nach Anspruch 12,
**dadurch gekennzeichnet, dass**
als Material für die Ladungsträger-Sperrschicht (4) ein halbleitendes Material verwendet wird.

**14.** Verfahren nach einem der Ansprüche 12 oder 13,
**dadurch gekennzeichnet, dass**
die Elektronenstrahlverdampfung bei einem Sauerstoffpartialdruck von $10^{-4b}$ bis $10^{-3}$ mbar vorgenommen wird.

**Geänderte Patentansprüche gemäss Regel 86(2) EPÜ.**

**1.** Organischer Feldeffekttransistor aufweisend:

ein Substrat (1), eine Sourceelektrode (2), eine Drainelektrode (6), wobei zwischen Sourceelektrode (2) und Drainelektrode (6) organisches, halbleitendes Material (3) angeordnet ist, eine Ladungsträger-Sperrschicht (4), welche auf dem organischen, halbleitenden Material (3) angeordnet ist und eine Gateelektrode (5), welche auf der Ladungsträger-Sperrschicht (4) angeordnet ist, wobei die Ladungsträger-Sperrschicht (4) ein halbleitendes Material aufweist,

**dadurch gekennzeichnet, dass**

der energetische Abstand (15) zwischen dem Leitungsband der Ladungsträger-Sperrschicht (4) und dem Leitungsband des halbleitenden Materials (3) sowie der energetische Abstand (16) zwischen dem Valenzband der Ladungsträger-Sperrschicht (4) und dem Valenzband des halbleitenden Materials (3) größer als 1,0 eV ist.

**2.** Feldeffekttransistor nach Anspruch 1,
**dadurch gekennzeichnet, dass**
die Ladungsträger-Sperrschicht (4) vollständig aus einem halbleitendes Material besteht.

**3.** Feldeffekttransistor nach einem der vorhergehenden Ansprüche,
**dadurch gekennzeichnet, dass**
die Energie des Leitungsbandes der Ladungsträger-Sperrschicht (4) niedriger ist als die Austrittsarbeit der Gateelektrode (5).

**4.** Feldeffekttransistor nach Anspruch 3,
**dadurch gekennzeichnet, dass**
der energetische Abstand zwischen Ladungsträger-Sperrschicht (4) und halbleitendem Material (3) größer 1,0 eV, insbesondere 1,5 eV beträgt.

**5.** Feldeffekttransistor nach Anspruch 3,
**dadurch gekennzeichnet, dass**
der energetische Abstand zwischen dem Leitungsband der Ladungsträger-Sperrschicht (4) und der Austrittsarbeit der Gateelektrode (5) kleiner 0,2 eV, insbesondere 0,1 eV ist.

**6.** Feldeffekttransistor nach einem der vorhergehenden Ansprüche,
**dadurch gekennzeichnet, dass**
das halbleitende Material (3) für einen p-Kanal-Transistor Pentacen, Tetracen, Phtalocyanine, Oligothiophene, Polyalkylthiophene, Copolymere von Alkylthiophenen mit Alkylfluoreneinheiten, Polyfluorene, Poly-(thienylenvinylene), Poly(phenylenvinylene), und/oder Homopolymere mit Phenylen, Napthalen- und/oder Anthranyleinheiten umfasst sowie für einen n-Kanal-Transistor Derivate von Perylentetracarbonsäurediimid sowie Napthalintetracarbonsäurediimid und Fullerene.

**7.** Feldeffekttransistor nach einem der vorhergehenden Ansprüche,
**dadurch gekennzeichnet, dass**
die Ladungsträger-Sperrschicht (4) für einen p-Kanal-Transistor Titandioxid, undotiertes Zinnoxid, undotiertes Zinkoxid, Zirkoniumdioxid, Tantaloxid und/oder Zinksulfid umfasst und im Falle eines n-Kanal-Transistors bevorzugt Derivate oligomerer Arylamine.

**8.** Feldeffekttransistor nach einem der vorhergehenden Ansprüche,
**dadurch gekennzeichnet, dass**
die Gateelektrode (5) im Falle eines p-Kanal-Transistors Magnesium, eine Silber aufweisende Magnesiumlegierung, Calcium, Barium, und/oder ein Lanthanid und im Falle eines n-Kanal-Transistors Gold, Nickel, Palladium oder Platin umfasst.

**9.** Feldeffekttransistor nach Anspruch 8,
**dadurch gekennzeichnet, dass**
das Lanthanid Cer oder Ytterbium ist.

**10.** Feldeffekttransistor nach Anspruch 8,
**dadurch gekennzeichnet, dass**
die Magnesiumlegierung eine Legierung von Magnesium und Silber im Verhältnis von 1:9 umfasst.

**11.** Feldeffekttransistor nach einem der vorhergehenden Ansprüche,
**dadurch gekennzeichnet, dass**
die Sourceelektrode (2) und/oder die Drainelektrode (6) im Falle eines p-Kanal-Transistors Gold, Palladium, Platin und/oder leitfähige Polymere, insbesondere Poly(ethylendioxothiophen)/Polystyrolsulfonsäure und im Falle n-Kanal-Transistors Aluminium, Titan, Magnesium und/oder Silber umfassen.

**12.** Verfahren zur Herstellung eines organischen Feldeffekttransistors mit folgenden Verfahrensschritten:

- Aufbringen einer Sourceelektrode (2), Aufbringen einer Drainelektrode (6) und Aufbringen von organischem, halbleitenden Material (3) auf ein Substrat (1),

- Aufbringen einer Ladungsträger-Sperrschicht (4) aus einem halbleitenden Material und Aufbringen einer Gateelektrode (5),

**dadurch gekennzeichnet, dass**
die Ladungsträger-Sperrschicht (4) mittels thermischem Verdampfen oder mittels Elektronenstrahlverdampfung aufgebracht wird.

**13.** Verfahren nach Anspruch 12,
**dadurch gekennzeichnet, dass**
als Material für die Ladungsträger-Sperrschicht (4) ein halbleitendes Material verwendet wird.

**14.** Verfahren nach einem der Ansprüche 12 oder 13,
**dadurch gekennzeichnet, dass**
die Elektronenstrahlverdampfung bei einem Sauerstoffpartialdruck von $10^{-4\,b}$ bis $10^{-3}$ mbar vorgenommen wird.

Fig. 1

Fig. 2

Fig. 3

**Europäisches Patentamt**

**EUROPÄISCHER RECHERCHENBERICHT**

Nummer der Anmeldung

EP 04 09 0119

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | EP 1 398 840 A (PIONEER CORP) 17. März 2004 (2004-03-17) * das ganze Dokument * ----- | 1,2,6-8, 11-13 | H01L51/20 |
| X | MIYAUCHI S ET AL: "JUNCTION FIELD-EFFECT TRANSISTOR USING POLYTHIOPHENE AS AN ACTIVE COMPONENT" SYNTHETIC METALS, ELSEVIER SEQUOIA, LAUSANNE, CH, Bd. 41 - 43, 1991, Seiten 1155-1158, XP000827738 ISSN: 0379-6779 * Abbildung 1 * ----- | 1-3 | |
| X | WO 03/028125 A (3M INNOVATIVE PROPERTIES CO) 3. April 2003 (2003-04-03) * Seite 17, Zeile 25 - Seite 19, Zeile 24 * ----- | 1,2,6-8, 11 | |
| X | US 6 207 472 B1 (CALLEGARI ALESSANDRO CESARE ET AL) 27. März 2001 (2001-03-27) * Abbildung 6 * ----- | 1,2,6-8, 11 | RECHERCHIERTE SACHGEBIETE (Int.Cl.7) H01L |
| X | US 6 232 157 B1 (RAJU VENKATARAM REDDY ET AL) 15. Mai 2001 (2001-05-15) * Spalte 6, Zeile 16 - Zeile 25; Abbildung 17 * ----- | 1,6 | |
| A | US 2002/195644 A1 (KATZ HOWARD E ET AL) 26. Dezember 2002 (2002-12-26) * Absatz [0026]; Abbildungen 4A-4E * ----- | | |

Der vorliegende Recherchenbericht wurde für alle Patentansprüche erstellt

| Recherchenort | Abschlußdatum der Recherche | Prüfer |
|---|---|---|
| München | 18. August 2004 | Pusch, C |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 04 09 0119

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

18-08-2004

| Im Recherchenbericht angeführtes Patentdokument | | Datum der Veröffentlichung | Mitglied(er) der Patentfamilie | | Datum der Veröffentlichung |
|---|---|---|---|---|---|
| EP 1398840 | A | 17-03-2004 | JP<br>EP<br>US | 2004103905 A<br>1398840 A2<br>2004108562 A1 | 02-04-2004<br>17-03-2004<br>10-06-2004 |
| WO 03028125 | A | 03-04-2003 | EP<br>WO<br>US | 1433211 A2<br>03028125 A2<br>2003105365 A1 | 30-06-2004<br>03-04-2003<br>05-06-2003 |
| US 6207472 | B1 | 27-03-2001 | JP<br>US | 2000269515 A<br>2001015438 A1 | 29-09-2000<br>23-08-2001 |
| US 6232157 | B1 | 15-05-2001 | US<br>EP<br>JP<br>KR<br>TW | 6215130 B1<br>0981165 A1<br>2000068523 A<br>2000017418 A<br>413951 B | 10-04-2001<br>23-02-2000<br>03-03-2000<br>25-03-2000<br>01-12-2000 |
| US 2002195644 | A1 | 26-12-2002 | JP | 2003046006 A | 14-02-2003 |

EPO FORM P0461

Für nähere Einzelheiten zu diesem Anhang : siehe Amtsblatt des Europäischen Patentamts, Nr.12/82